# EUROPEAN PATENT APPLICATION

(11) **EP 3 663 260 A1**
(43) Date of publication of application: **10.06.2020**
(21) Application number: 19204641.5
(22) Date of filing: 21.09.2017
(51) Int. Cl.: C01B 33/107, C01B 21/068, C01B 32/963, C01B 33/12, C07F 7/02, C23C 16/34, C23C 16/455, C01B 21/082, C07F 7/12

(54) **PREPARING A SILICON-HETEROATOM COMPOUND USING CHLORODISILAZANES**

(30) Priority: 28.09.2016 US 201662400720 P
(62) Divisional of application: 17787988.9
(71) Applicant: Dow Silicones Corporation, Midland, MI 48686-0994 (US)
(72) Inventor: HWANG, Byung K., MIDLAND, MI Michigan 48642 (US); REKKEN, Brian D., Midland, MI Michigan 48460 (US); TELGENHOFF, Michael D., Midland, MI Michigan 48640 (US); ZHOU, Xiaobing, Midland, MI Michigan 48640 (US)
(74) Representative: Murgitroyd & Company

(57) **Abstract**

Silicon-heteroatom compounds synthesized using chlorodisilazanes; devices containing the silicon-heteroatom compounds; the silicon-heteroatom compounds, and the devices; and uses of the silicon-heteroatom compounds, and devices.

## Description

### TECHNICAL FIELD

Chlorodisilazanes; silicon-heteroatom compounds synthesized therefrom; films of and devices containing the silicon-heteroatom compounds; methods of making the chlorodisilazanes, silicon-heteroatom compounds, films, and devices; and uses of the chlorodisilazanes, silicon-heteroatom compounds, films, and devices.

### BACKGROUND OF THE RELATED ART

Films of silicon-heteroatom compounds may act as dielectric, barrier, or stressor layers in electronic devices or microelectromechanical system (MEMS). The films may be formed on a surface of a component of the electronic device or MEMS in need of such action by subjecting one or more suitable precursor compounds to film deposition methods in the presence of the component. The precursor compounds are small molecules, oligomers, or macromolecules that vaporize and react with or decompose on the surface of the component in such a way so as to form a thin conformal coating of the silicon-heteroatom compound thereon. In order to form satisfactorily-performing films, incumbent precursor compounds may need to be heated at high temperatures (e.g., 600° to 1,000° C.).

### BRIEF SUMMARY OF THE INVENTION

We (the present inventors) have discovered problems with incumbent precursor compounds. Some incumbent precursor compounds contain impurities that will contaminate the electronic device or MEMS. In order to form satisfactory films of silicon-heteroatom compounds some incumbent precursor compounds need to be heated at temperatures that degrade thermally-sensitive features of the components being coated. Also, some of the films may be defective, e.g., undesired thicknesses or densities or lacking satisfactory uniformity.

Our technical solution to this problem(s) comprises one or more chlorodisilazanes and their use as precursor compounds; silicon-heteroatom compounds synthesized therefrom; films of and devices containing the silicon-heteroatom compounds; methods of making the chlorodisilazanes, silicon-heteroatom compounds, films, and devices; and uses of the chlorodisilazanes, silicon-heteroatom compounds, films, and devices.

### DETAILED DESCRIPTION OF THE INVENTION

The Brief Summary and Abstract are incorporated here by reference. This invention is described herein in an illustrative manner by disclosing a plurality of representative, non-limiting embodiments and examples. In some embodiments the invention is any one of the following numbered aspects.

Aspect 1. 1,1,1,3,3-Pentachlorodisilazane. I.e., Cl₂HSiN(H)SiCl₃.

Aspect 2. A method of making 1,1,1,3,3-pentachlorodisilazane, the method comprising contacting 1,1,1-trichloro-3,3,3-trimethyldisilazane with trichlorosilane (HSiCl₃) to give 1,1,1,3,3-pentachlorodisilazane. In some embodiments the method further comprises (i) a preliminary step of contacting tetrachlorosilane (SiCl₄) with 1,1,1,3,3,3-hexamethyldisilazane ((CH₃)₃SiN(H)Si(CH₃)₃) to give the 1,1,1-trichloro-3,3,3-trimethyldisilazane (Cl₃SiN(H)Si(CH₃)₃); or (ii) wherein the 1,1,1,3,3-pentachlorodisilazane is in need of purification and the method further comprises purifying the 1,1,1,3,3-pentachlorodisilazane to give a bulk form thereof containing from 70 to 100 area percent (Gas Chromatography) ("area% (GC)") of 1,1,1,3,3-pentachlorodisilazane based on total weight of the bulk form; or (iii) both (i) and (ii). Alternatively, a method of making 1,1,1,3,3-pentachlorodisilazane, the method comprising contacting 3 mole equivalents of ammonia (NH₃) with 1 mole equivalent of trichlorosilane (HSiCl₃) and 1 mole equivalent of tetrachlorosilane (SiCl₄) to give one mole equivalent of the 1,1,1,3,3-pentachlorodisilazane and two mole equivalents of ammonium chloride (NH₄Cl).

Aspect 3. A method of treating an initial surface of a substrate, the method comprising a first contacting step comprising contacting the initial surface of the substrate with a vapor of a chlorodisilazane of formula (I): X¹Cl₂SiN(H)SiCl₂X² (I), wherein each of X¹ and X² independently is H or Cl, using a first deposition method to give a product comprising a treated surface on the substrate. Prior to the first contacting step the initial surface of the substrate is ready to receive the silicon-heteroatom compound and may be in need of a dielectric, barrier or stressor layer. The initial surface of the substrate is different than the treated surface of the substrate in at least one of composition, reactivity, or functionality.

Aspect 4. A method of making a silicon-heteroatom compound, the method comprising a first contacting step comprising contacting the initial surface of the substrate with a vapor of a chlorodisilazane of formula (I): X¹Cl₂SiN(H)SiCl₂X² (I), wherein each of X¹ and X² independently is H or Cl, using a first deposition method to give a treated surface on the substrate; and a second contacting step comprising contacting the initial surface or the treated surface of the substrate with a vapor or plasma of a precursor material containing nitrogen atom(s), oxygen atom(s), carbon atom(s), or a combination of any two or more atoms thereof using a second deposition method to give a product comprising a silicon-heteroatom compound formed with or on the initial or treated surface of the substrate. The chlorodisilazane of formula (I) is a compound that is a molecule or a collection of molecules wherein each molecule is independently of formula (I). Prior to the first contacting step the initial surface of the substrate is ready to receive the silicon-heteroatom compound and may be in need of a dielectric, barrier or stressor layer. The initial surface of the substrate is different than the treated surface of the substrate in at least one of composition, reactivity, or functionality. The first deposition method may be the same as or different than the second deposition method. One or both of the first and second deposition methods may be film-forming methods. The composition of the silicon-heteroatom compound is different than the compositions of the treated surface of the substrate and the initial surface of the substrate. The silicon-heteroatom compound may be made as a film, a particulate solid, or a designed structure on the initial surface of the substrate.

Aspect 5. The method of aspect 3 or 4 wherein the chlorodisilazane of formula (I) is 1,1,3,3-tetrachlorodisilazane (X¹ = X² = H) or 1,1,1,3,3,3-hexachlorodisilazane (X¹ = X² = CI). In some aspects of the chlorodisilazane of formula (I) X¹ = X² = H, alternatively X¹ = X² = Cl.

Aspect 6. The method of aspect 3 or 4 wherein the chlorodisilazane of formula (I) is 1,1,1,3,3-pentachlorodisilazane. (X¹ = Cl; X² = H)

Aspect 7. The method of any one of aspects 4 to 6 wherein the precursor material containing nitrogen atom(s) is molecular nitrogen, ammonia, hydrazine, an organohydrazine, hydrogen azide, a primary amine, or a secondary amine; the precursor material containing oxygen atom(s) is molecular oxygen, ozone, water, nitrous oxide (N₂O), or hydrogen peroxide; and the precursor material containing carbon atom(s) is methane, ethane, propane, a butane, a chloromethylsilane, a permethylsilane having from 1 to 5 Si atoms, or a methylhydridosilane having 1 to 5 Si atoms.

Aspect 8. The method of any one of aspects 4 to 6 wherein the precursor material further contains silicon atom(s), hydrogen atom(s), chlorine atom(s), or a combination of any two or more atoms thereof.

Aspect 9. The method of any one of aspects 4 to 8 wherein (i) the first contacting step is completed before the second contacting step is performed such that the second contacting step comprises contacting the treated surface of the substrate with the vapor or plasma of a precursor material; or (ii) the method comprises atomic layer deposition; or (iii) both (i) and (ii). In some aspects, the method is (i), alternatively (ii), alternatively (iii). The atomic layer deposition may be plasma-enhanced.

Aspect 10. The method of any one of aspects 4 to 8 wherein (i) the first and second contacting steps are performed simultaneously such that the second contacting step comprises contacting the initial surface of the substrate with the vapor or plasma of a precursor material; or (ii) the method comprises chemical vapor deposition; or (iii) both (i) and (ii). In some aspects, the method is (i), alternatively (ii), alternatively (iii). The chemical vapor deposition may be plasma-enhanced.

Aspect 11. The method of any one of aspects 4 to 10 wherein (i) the silicon-heteroatom compound that is made is a silicon carbide, a silicon nitride, a silicon dioxide, a silicon oxynitride, a silicon carbonitride, a silicon oxycarbide, or a silicon oxycarbonitride; or (ii) the silicon-heteroatom compound is made in the shape of a film on the initial surface of substrate; or (iii) both (i) and (ii).

Aspect 12. The method of any one of aspects 4 to 11 further comprising a step of separating the silicon-heteroatom compound of the product from the substrate of the product so as to give the separated silicon-heteroatom compound as a free-standing bulk form.

Aspect 13. The silicon-heteroatom compound made by the method of any one of aspects 4 to 12.

Aspect 14. A manufactured article comprising the product made by the method of any one of aspects 3 to 12 or the silicon-heteroatom compound of aspect 13. The manufactured article may be an electronic device or a microelectromechanical system (MEMS), wherein the product is a component of the electronic device or MEMS.

We present technical solutions to several problems. One technical solution is a precursor, 1,1,1,3,3-pentachlorodisilazane, for forming silicon-heteroatom compounds.

Another technical solution is a method of treating a surface of a substrate. The surface of the substrate is in need of treatment.

Another technical solution is a method of forming silicon-heteroatom compound, the new method comprising using as a precursor the chlorodisilazane of formula (I).

Another technical solution is a way to lower the deposition temperature below 600° C.

The 1,1,3,3-tetrachlorodisilazane may be made by a method comprising contacting 3 mole equivalents of ammonia (NH₃) with 2 mole equivalents of trichlorosilane (HSiCl₃) to give one mole equivalent of the 1,1,3,3-tetrachlorodisilazane and two mole equivalents of ammonium chloride (NH₄Cl).

The 1,1,1,3,3-pentachlorodisilazane may be made by the method of aspect 2.

The 1,1,1,3,3,3-hexachlorodisilazane may be made by a method comprising contacting 2 mole equivalents of tetrachlorosilane (SiCl₄) with 3 mole equivalents of ammonia (NH₃) to give 1 mole equivalent of 1,1,1,3,3,3-hexachlorodisilazane and 2 mole equivalents of ammonium chloride (NH₄Cl). The 1,1,1,3,3,3-hexachlorodisilazane has CAS RegNo. 14657-30-8 and is available from commercial suppliers such as MOLBASE.com.

The chlorodisilazane of formula (I) as prepared in bulk form may be of sufficient purity to be used in the method of making the silicon-heteroatom compound. In some embodiments the bulk form of the chlorodisilazane of formula (I) as prepared may be in need of purification. The synthesis of the chlorodisilazane of formula (I) may further comprise purifying the bulk form of same such as by fractional distillation or gas chromatography.

Purity of the bulk form of the chlorodisilazane of formula (I) and other precursor materials may be determined by ²⁹Si-NMR, reverse phase liquid chromatography or, more likely, by gas chromatography (GC) as described later. For example, the purity determined by GC may be from 60 area% to ≤ 100 area% (GC), alternatively from 70 area% to ≤ 100 area% (GC), alternatively from 80 area% to ≤ 100 area% (GC), alternatively from 90 area% to ≤ 100 area% (GC), alternatively from 93 area% to ≤ 100 area% (GC), alternatively from 95 area% to ≤ 100 area% (GC), alternatively from 97 area% to ≤ 100 area% (GC), alternatively from 99.0 area% to ≤ 100 area% (GC). Each ≤ 100 area% (GC) independently may be as defined previously.

The silicon-heteroatom compound consists of silicon and at least one heteroatom selected from carbon, nitrogen and oxygen. The silicon-heteroatom compound may consist of silicon carbide (Si and C atoms), silicon nitride (Si and N atoms), silicon dioxide (Si and O atoms), silicon carbonitride (Si, C and N atoms), silicon oxycarbide (Si, C and O atoms), silicon oxycarbonitride (Si, C, N and O atoms), or silicon oxynitride (Si, N and O atoms). A bulk form of the silicon-heteroatom compound (a collection of two or more molecules) may be free of additional elements or, optionally, may further contain one or more dopants and/or one or more impurities. Dopants are elements other than Si, C, N, and O that are intentionally added to the bulk form in measured amounts to enhance the properties of the bulk material in a particular application. An impurity is an element other than Si, C, N, and O and dopants that contaminates the bulk form, wherein the lower the concentration of impurity element(s) the better. Ideally the bulk form of the silicon-heteroatom compound is free of impurities (i.e., 0% concentration of impurity element(s)).

The method of making the silicon-heteroatom compound comprises the first and second deposition methods. The deposition methods that may be used herein are not particularly limited and include any of the well-known deposition techniques, deposition apparatuses, and associated operating conditions for manipulating precursor materials for depositing a silicon-heteroatom compound onto a substrate. Deposition techniques, apparatuses and their associated operating conditions that are suitable for use in the method of making the silicon-heteroatom compound are generally well-known in the art. The deposition methods generally involve placing a substrate in a reaction chamber of a deposition apparatus; evacuating the reaction chamber housing the substrate; heating the substrate in the reaction chamber; generating one or more precursors outside the reaction chamber; feeding the precursor(s) into the reaction chamber, wherein when two or more precursors are used the feeding thereof may be sequentially or simultaneously; and either allowing the precursor(s) to be absorbed onto the surface of the heated substrate, where they may decompose to form the silicon-heteroatom compound, or to react chemically to give the silicon-heteroatom compound in the vaporous form, which is subsequently absorbed onto the surface of the heated substrate, stopping the feeding of the precursor(s), cooling the substrate and removing it from the reaction chamber to give the product.

In certain embodiments each deposition method independently comprises physical vapor deposition, atomic layer deposition (ALD), or chemical vapor deposition (CVD). The physical vapor deposition method may comprise sputtering. Suitable sputtering methods include direct current (DC) magnetron sputtering, ion-beam sputtering, reactive sputtering, and ion-assisted sputtering. Typically, the deposition method comprises ALD or CVD.

Suitable ALD methods include plasma enhanced atomic layer deposition methods (PEALD), spatial atomic layer deposition (SALD) and thermal atomic layer deposition (TALD) methods. When PEALD methods are employed, the plasma may be any one of the foregoing plasmas. The plasma may optionally further contain a carrier gas such as molecular nitrogen or argon gas. Plasmas are formed from plasma-forming gases, which may comprise a mixture of molecular nitrogen and molecular hydrogen.

Suitable CVD methods include simple thermal vapor deposition, plasma enhanced chemical vapor deposition (PECVD), electron cyclotron resonance (ECRCVD), atmospheric pressure chemical vapor deposition (APCVD), low pressure chemical vapor deposition (LPCVD), ultrahigh vacuum chemical vapor deposition (UHVCVD), aerosol-assisted chemical vapor deposition (AACVD), direct liquid injection chemical vapor deposition (DLICVD), microwave plasma-assisted chemical vapor deposition (MPCVD), remote plasma-enhanced chemical vapor deposition (RPECVD), atomic layer chemical vapor deposition (ALCVD), hot wire chemical vapor deposition (HWCVD), hybrid physical-chemical vapor deposition (HPCVD), rapid thermal chemical vapor deposition (RTCVD), and vapor-phase epitaxy chemical vapor deposition (VPECVD), photo-assisted chemical vapor disposition (PACVD), and flame assisted chemical vapor deposition (FACVD).

The CVD method may be conducted using a CVD apparatus that is a flowable chemical vapor apparatus, a thermal chemical vapor deposition apparatus, a plasma enhanced chemical vapor deposition apparatus, a photochemical vapor deposition apparatus, an electron cyclotron resonance apparatus, an inductively coupled plasma apparatus, a magnetically confined plasma apparatus, a low pressure chemical vapor deposition apparatus, or a jet vapor deposition apparatus. In certain embodiments the CVD technique and apparatus comprises plasma enhanced chemical vapor deposition, alternatively low pressure chemical vapor deposition. A suitable CVD technique and apparatus are Cyclic CVD and a Cyclic CVD apparatus.

The reaction chamber of the sputtering, ALD, or CVD deposition apparatus is a volumetrically enclosed space. The reaction chamber may host the operating conditions and house the substrate on which the silicon-heteroatom compound is to be formed. During the deposition method, the chlorodisilazane of formula (I), precursor material and any other deposition materials (e.g., inert gas or reactive species) are fed into the reaction chamber. The feeding may be sequential or simultaneous. In the reaction chamber, vapors, gases or plasmas for forming the film of the silicon-heteroatom compound may be mixed and reacted. The reaction forms the proper film elements or molecules in a vapor state. The elements or molecules then deposit on the substrate (e.g., a semiconductor wafer) and build up to form the film. All other things being equal, the longer the elements or molecules are allowed to build up, the greater the thickness of the film.

Techniques, apparatuses and operating conditions for the method of making the silicon-heteroatom compound and obtaining different film thicknesses may be optimized. Optimization may be based on considerations such as the particular chlorodisilazane of formula (I) and/or precursor material and any other materials used in the method, the particular composition of the silicon-heteroatom compound made, the desired purity of the silicon-heteroatom compound, the geometric configuration of the substrate, the device or application for which the silicon-heteroatom compound is intended to be incorporated or used, and economic (cost) considerations. Additional considerations are temperature of and pressure in the reaction chamber, concentration in the gas phase of the chlorodisilazane of formula (I), any additional reactant gas concentration (e.g., concentration of gas of any carbon precursor material, nitrogen precursor material, and/or oxygen precursor material), total gas flow, substrate temperature, and stability of the substrate. The oxygen precursor material, ozone, may be delivered at a concentration in air of from > 0 volume/volume percent (v/v%) to 5 v/v% or at a concentration in molecular oxygen of from > 0 v/v% to 14 v/v%. Whether optimized or not, the operating conditions lead to formation of the silicon-heteroatom compound by producing in the reaction chamber a chemical reaction such as pyrolysis, oxidation, reduction, hydrolysis, aminolysis (e.g., amination), carbonization, or a combination of any two or more thereof of the chlorodisilazane of formula (I) and any other precursor material.

The deposition methods generally require adding energy to the reaction chamber, such as evacuating the reaction chamber and heating the reaction chamber and substrate housed therein prior to the feeding of the chlorodisilazane of formula (I), precursor material and any other deposition materials thereinto. The deposition method may be conducted at less than atmospheric pressure such as a pressure from 1 to 13,000 pascals (Pa), alternatively 1 to 1,300 Pa, alternatively 10 to 1,300 Pa, alternatively 130 to 1,300 Pa. The temperature at which the deposition method is carried out may be isothermal or dynamic. Conventional deposition methods (not using the chlorodisilazane of formula (I)) generally require significantly higher deposition temperatures, such as greater than 600° C., e.g. 600° to 1000° C. However, it is believed that the chlorodisilazane of formula (I) may be utilized in the deposition method at much lower temperatures, e.g., from 100° to 700° C., alternatively from 200° to 700° C., alternatively from 200° to < 600° C., alternatively from 200° to 500° C., alternatively from 200° to 400° C., alternatively from 100° to 300° C.

Some embodiments of the method of making the silicon-heteroatom compound may further include a reactive environment comprising nitrous oxide (N₂O). In these embodiments the method generally involves decomposing the chlorodisilazane of formula (I) in the presence of nitrous oxide. Such a method is generally described in US 5,310,583. The nitrous oxide may modify the composition of the silicon-heteroatom compound made by the embodiments relative to embodiments of the method that do not include nitrous oxide.

Some embodiments of the method of making the silicon-heteroatom compound may further include an inert gas, which may be used in combination with the chlorodisilazane of formula (I) and/or with any one of the foregoing precursor materials. Examples of the inert gas are helium, argon, and mixtures thereof. For example, helium may be used in combination with the chlorodisilazane of formula (I) and/or any one of the carbon-containing precursor, nitrogen-containing precursor and oxygen-containing precursor in an embodiment of the method wherein the silicon-heteroatom compound that is formed is a silicon carbon compound, silicon nitrogen compound, or silicon oxygen compound, respectively.

A substrate is typically used in the method to provide a place where the silicon-heteroatom compound may be synthesized or deposited after its synthesis. The substrate is not particularly limited in composition or shape. In certain embodiments the substrate has sufficient thermal and/or chemical stability under the operating conditions such as the temperature and the reactive environment in the reaction chamber of the deposition apparatus. A suitable substrate may be composed of silicate glass, metal, plastic, ceramic, or a semiconductor material. The semiconductor material may be elemental silicon (e.g., monocrystalline silicon, polycrystalline silicon, or amorphous silicon). The surface of the substrate on which the silicon-heteroatom compound is to be deposited may be flat (planar) or patterned. The patterned surface may have features with an aspect ratio ranging from 1 to 500, alternatively from 1 to 50, alternatively from 10 to 50. The deposition method may form films that conformally coat the flat or patterned surface of the substrate. The pattern of the patterned surface of the substrate may be designed in such a way that the film of the silicon-heteroatom compound formed thereon has a designed complementary shape.

The deposition method typically forms the silicon-heteroatom compound as a film. The film is restricted in one dimension, which may be referred to as thickness thereof. The film may be an amorphous or crystalline material. The film may be crystalline or epitaxial. The film of the silicon-heteroatom compound may be a silicon carbon film, a silicon nitrogen film, or a silicon oxygen film. (e.g., silicon nitride, silicon carbonitride, silicon oxynitride, or silicon oxycarbonitride film, alternatively a silicon nitrogen film or a silicon oxygen film (e.g., silicon nitride, silicon oxide). The silicon carbon film formed by the method contains Si and C atoms and optionally N and/or O atoms. The silicon nitrogen film formed by the method contains Si and N atoms and optionally C and/or O atoms. The silicon oxygen film formed by the method contains Si and O atoms and optionally C and/or N atoms. In some aspects the film is disposed on a silicon wafer. In some aspects the silicon-heteroatom compound is a silicon nitride, alternatively a silicon carbide, alternatively a silicon dioxide, alternatively a silicon oxynitride, alternatively a silicon carbonitride, alternatively a silicon oxycarbide, alternatively a silicon oxycarbonitride.

Films of the silicon-heteroatom compound having different thicknesses may be formed using different deposition methods or operating conditions. The particular deposition method and operating conditions may impact the structure and properties of the film. Generally, it is possible to control the orientation of film structure, the manner in which the film coalesces, the uniformity of the film, and crystalline/non-crystalline structure of the film. The thickness of a particular film may be uniform, and different films having different thicknesses may be made for different intended end uses of the films. For instance, an embodiment of the film of the silicon-heteroatom compound may have a thickness of a few nanometers, whereas another embodiment may have a thickness of a few microns, and still another embodiment may have a greater or lesser thickness or a thickness falling in-between. In some embodiments the film has a thickness of from 0.01 to 1,000 nanometers (nm), alternatively 0.1 to 100 nm, alternatively 1 to 100 nm.

Once formed, the silicon-heteroatom compound (e.g., film thereof) may be used as is, i.e., in an uncovered state. The film may be used while it is disposed on the substrate, or the film may be separated from the substrate before it is used.

Alternatively, the silicon-heteroatom compound (e.g., film thereof) optionally may be covered by one or more top coatings. Each top coating may be independently composed of an embodiment of the silicon-heteroatom compound or a different material and independently may be formed by the method of making the silicon-heteroatom compound or by a different (non-invention) method. The non-invention method may use a precursor material other than the chlorodisilazane of formula (I). Examples of a top coating that may cover the (film of the) silicon-heteroatom compound are a SiO₂ coating, a SiO₂/modifying ceramic oxide layer, a silicon-containing coating, a silicon carbon-containing coating, a silicon carbide-containing coating, a silicon nitrogen-containing coating, a silicon nitride-containing coating, a silicon nitrogen carbon-containing coating, a silicon oxygen nitrogen containing coating, and a diamond-like carbon coating. Such top coatings and suitable methods of making are generally known in the art.

Because the chlorodisilazane of formula (I) contains two Si-N bonds, in some embodiments the chlorodisilazane of formula (I) may be utilized to form silicon nitride films without use of the nitrogen-containing precursor. Alternatively, the nitrogen-containing precursor may be also used, if desired.

The silicon-heteroatom compound may be useful in electronics and photovoltaic devices and applications. Such uses include the silicon-heteroatom compound in the shape of the film, a plurality of particles, or a designed structure; whether the compound is disposed on the substrate or is free-standing; and whether the compound is an uncovered state or is top covered as described above. The silicon-heteroatom compound may be used as a dielectric, barrier, or stressor material. Silicon nitride film embodiments of the silicon-heteroatom compound may be act as an insulator layer, passivation layer, or a dielectric layer between polysilicon layers in capacitors.

In addition, operating conditions of the deposition method may be adjusted to control whether the method forms an elemental Si film or a silicon-heteroatom compound such as a SiN film. In an additional aspect, the invention further includes a method of forming an elemental silicon film that is free of heteroatoms N, C, and O, the method comprising the first contact step of aspect 3.

This description has been intentionally written such that any one stated feature or limitation of an example, any one stated Markush subgenus or species, or any one stated number of a range or subrange, may be relied upon and provides adequate support for amending the claims.

Unless otherwise defined herein, meanings of chemical technology terms used herein may be found in IUPAC. Compendium of Chemical Terminology, 2nd ed. (the "Gold Book"). Compiled by A. D. McNaught and A. Wilkinson. Blackwell Scientific Publications, Oxford (1997). XML on-line corrected version: http://goldbook.iupac.org (2006-) created by M. Nic, J. Jirat, B. Kosata; updates compiled by A. Jenkins. ISBN 0-9678550-9-8. doi:10.1351/goldbook. Hawley's CONDENSED CHEMICAL DICTIONARY, 11th edition, N. Irving Sax & Richard J. Lewis, Sr., 1987 (Van Nostrand Reinhold) may have terms not defined by IUPAC.

Unless otherwise defined herein, meanings of general terms used herein may be found here. Alternatively precedes a distinct embodiment. Articles "a", "an", and "the" each refer to one or more. Chemical element or atom, a Group or Groups of chemical elements shall mean those published by IUPAC in the Periodic Table of the Elements, version dated 01 May 2013. Any comparative example is used for illustration purposes only and shall not mean prior art. A synthesized product may have a structure that can be varied depending upon the particular reactants and synthesis conditions used to make it. That variability is not unlimited, but is restricted according to the structure of the reactants and synthesis chemistry and conditions. Free of or lacks means a complete absence of; alternatively not detectable, e.g., using nuclear magnetic resonance (NMR) spectroscopy (e.g., ¹H-NMR, ¹³C-NMR, or ²⁹Si-NMR) or Fourier Transform-Infrared (FT-IR) spectroscopy. Invention and inventive shall mean a representative embodiment or aspect, and shall not be interpreted as constituting the entire invention. IUPAC is International Union of Pure and Applied Chemistry (IUPAC Secretariat, Research Triangle Park, North Carolina, USA). Markush group comprises a genus of two or more members. A Markush group of members A and B may be equivalently expressed as: "a member selected from A and B"; "a member selected from the group consisting of A and B"; or "a member A or B". Each member may independently be a subgenus or species of the genus. May confers a permitted choice, not an imperative. Operative means functionally capable or effective. Optional(ly) means is absent (or excluded), alternatively is present (or included). Properties are measured using a standard test method and conditions for the measuring. Ranges of numbers include endpoints, subranges, and whole and/or fractional values subsumed therein, except a range of integers does not include fractional values. Removing a component from a mixture of components does not include selectively derivatizing/reacting the component to form a derivative/product unless the derivative/product is physically separated from the other components of the mixture. Vehicle means a liquid acting as a carrier, dispersant, diluent, storage medium, supernatant, or solvent for another material, which may or may not be soluble therein.

Any compound herein includes all its isotopic forms, including natural abundance forms and isotopically-enriched forms. In some aspects, the isotopic form is the natural abundance form, alternatively the isotopically-enriched form. The isotopically-enriched forms may have additional uses, such as medical or anti-counterfeiting applications, wherein detection of the isotopically-enriched compound is helpful in treatment or detection.

In some aspects any composition described herein may contain any one or more of the chemical elements of Groups 1 to 18 of the Periodic Table of the Elements. In some aspects at least one such chemical element is specifically excluded from the composition, except not excluded are Si, O, H, C, N, and Cl. In some aspects the specifically excluded chemical elements may be: (i) at least one chemical element from any one of Groups 2 to 13 and 18, including the lanthanoids and actinoids; (ii) at least one chemical element from any one of the third to sixth rows of the Periodic Table of the Elements, including the lanthanoids and actinoids; or (iii) both (i) and (ii), except not excluding Si, O, H, C, N, and Cl.

### EXAMPLES

The invention is further illustrated by, and an invention embodiment may include any combinations of features and limitations of, the non-limiting examples thereof that follow. Ambient temperature is about 23°C, and all percentages are weight percent unless indicated otherwise.

**Table 1. Abbreviations used in the Examples.**

| Abbreviation | |
|---|---|
| sccm | Standard cubic centimeters per minute |
| °C | Degrees Celsius |
| WER | Wet etch rate |
| GPC | Growth per cycle measured in angstroms (A) |
| RI | Refractive Index |
| nm | Nanometers |
| RF | Plasma power in Watts |
| SiN | Silicon nitride |
| HF | Hydrogen Fluoride |
| min | Minute |
| FG | Forming gas (10% H₂ and balance N₂) |
| A | Angstroms |

Thin Film Characterization Method: The thickness of thin film and refractive index (at 632.8 nm) of silicon nitride were measured using spectroscopic ellipsometry (M-2000DI, J.A. Woollam). Ellipsometry data were collected from 375 nm to 1690 nm and analyzed using either Cauchy or Tauc-Lorentz oscillator model with a software provided by J.A. Woollam.

Wet Etch Rate (WER): Wet etch rate tests of the thin films grown by PEALD SiN process were performed using 500:1 HF:water solution at room temperature. The wet etch rate was calculated from the thickness difference before and after etching for a specified amount of time.

Gas Chromatography-Flame Ionization Detector (GC-FID) conditions: a capillary column with 30 meters length, 0.32 mm inner diameter, and containing a 0.25 µm thick stationary phase in the form of a coating on the inner surface of the capillary column, wherein the stationary phase was composed of phenyl methyl siloxane. Carrier gas is helium gas used at a flow rate of 105 mL per minute. GC instrument is an Agilent model 7890A gas chromatograph. Inlet temperature is 200° C. GC experiment temperature profile consist of soaking (holding) at 50° C. for 2 minutes, ramping temperature up at a rate of 15° C./minute to 250° C., and then soaking (holding) at 250° C. for 10 minutes.

GC-MS instrument and conditions: Sample is analyzed by electron impact ionization and chemical ionization gas chromatography-mass spectrometry (El GC-MS and Cl GC-MS). Agilent 6890 GC conditions include a DB-1 column with 30 meters (m) x 0.25 millimeter (mm) x 0.50 micrometer (µm) film configuration. An oven program of soaking at 50° C. for 2 minutes, ramping at 15° C./minute to 250° C., and soaking at 250° C. for 10 minutes. Helium carrier gas flowing at constant flow of at 70 mL/minute and a 50:1 split injection. Agilent 5973 MSD conditions include a MS scan range from 15 to 800 Daltons, an El ionization and Cl ionization using a custom Cl gas mix of 5% NH₃ and 95% CH₄.

Preparation 1: synthesis of 1,1,1-trichloro-3,3,3-trimethyldisilazane. Added 23.75 grams (g) of hexamethyldisilazane to 100 g of boiling SiCl₄ over 5 minutes, and then refluxed the resulting mixture for 5 hours to give crude 1,1,1-trichloro-3,3,3-trimethyldisilazane ((CH₃)₃SiNHSiCl₃). Fractionally distilled the crude 1,1,1-trichloro-3,3,3-trimethyldisilazane through a 30 centimeter (cm) Vigreux column to give 25.39 g of 98 area% (GC) pure 1,1,1-trichloro-3,3,3-trimethyldisilazane.

Example 1: synthesis of 1,1,1,3,3-pentachlorodisilazane. Dissolved 15.03 g of the purified 1,1,1-trichloro-3,3,3-trimethyldisilazane of Preparation 1 in 10.00 g of hexadecane in a 100 mL 3-neck flask fitted with a thermocouple and a reflux condenser. To the resulting solution added 27.43 g of trichlorosilane, and placed a rubber septum on top of the condenser. Heated the resulting mixture to approximately 45° C., and released excess pressure through the septum. Then further heated the mixture to approximately 60° C., and stirred the mixture thereat for 1 week. Allowed the resulting reaction mixture to cool, and obtained 1,1,1,3,3-pentachlorodisilazane in 23% yield in a crude mixture.

Example 2: purification of 1,1,1,3,3-pentachlorodisilazane. Distilled the 1,1,1,3,3-pentachlorodisilazane of Example 1 through a 30 cm Vigreux column to give 2.05 g (12.2% yield) of 1,1,1,3,3-pentachlorodisilazane having a purity of 85 area% (GC).

Example 3-15: forming a silicon nitride film using the 1,1,1,3,3,3-hexachlorodisilazane (HCDZ) with nitrogen containing gases and PEALD: a PEALD reactor that contained a plurality of horizontally oriented and spaced apart silicon wafers heated to the set point of 350 - 500 °C and a small cylinder containing HCDZ in fluid communication with the PEALD reactor were used to produce films on the wafers. The cylinder was maintained at the room temperature or heated to increase vapor pressure thereof. The PEALD reactor was purged with nitrogen (N₂) then PEALD SiN films were grown with HCDZ in the following sequences: HCDZ dose, 1 sec / N₂ Purge, 30 sec / Plasma with nitrogen containing gases, such as NH₃ + Argon, NH₃ + N₂, Forming gas (10% H₂ in N₂) + Argon, for 15 sec / N₂ Purge, 30 sec. The foregoing sequence of steps was repeated until a silicon nitride film with a desired thickness was formed on the wafers. The films were then evaluated for wet etch rate. The parameters used to generate the films and test results for each example are listed in Table 2.

**Table 2. Film parameters and RI and WER test results for examples 3 to 15.**

| Example # | Precursor | Set Temp (°C) | RF Power** (W) | Plasma Gas (flow rate, sccm) | GPC (Å/cycl e) | RI at 632.8nm | WER of PEALD SiN in 500:1 HF solution (nm/min) |
|---|---|---|---|---|---|---|---|
| 3 | HCDZ | 350 | 200 | Ar/NH3 (50/25 sccm) | 0.57 | 1.80 | 3.1 |
| 4 | HCDZ | 500 | 200 | Ar/NH3 (50/25 seem) | 0.53 | 1.81 | 2.0 |
| 5 | HCDZ | 350 | 100 | Ar/NH3 (50/25 sccm) | 0.52 | 1.86 | 1.7 |
| 6 | HCDZ | 400 | 100 | Ar/NH3 (50/25 seem) | 0.47 | 1.87 | 1.1 |
| 7 | HCDZ | 500 | 100 | Ar/NH3 (50/25 seem) | 0.46 | 1.88 | 0.6 |
| 8 | HCDZ | 350 | 100 | N2/NH3 (50/25 sccm) | 0.59 | 1.80 | 8.2 |
| 9 | HCDZ | 500 | 100 | N2/NH3 (50/25 sccm) | 0.55 | 1.82 | 4.0 |
| 10 | HCDZ | 400 | 200 | N2/NH3 (30/90 sccm) | 0.73 | 1.77 | 6.5 |
| 11 | HCDZ | 400 | 100 | N2/NH3 (30/90 seem) | 0.67 | 1.81 | 5.6 |
| 12 | HCDZ | 450 | 100 | N2/NH3 (30/90 seem) | 0.66 | 1.81 | 4.7 |
| 13 | HCDZ | 500 | 100 | N2/NH3 (30/90 seem) | 0.65 | 1.81 | 4.3 |
| 14 | HCDZ | 350 | 100 | Ar/FG (50/50 sccm) | 0.42 | 1.80 | 2.1 |
| 15 | HCDZ | 500 | 100 | Ar/FG (50/50 sccm) | 0.42 | 1.8 | 1 |

| | | | | | | | |
|---|---|---|---|---|---|---|---|
| *FG = Forming gas (10% H2 in N2) | | | | | | | |

**Examples 16- 28:** forming a silicon oxide film using the 1,1,1,3,3,3-hexachlorodisilazane (HCDZ) with oxidant gases in ALD: a ALD reactor that contained a plurality of horizontally oriented and spaced apart silicon wafers heated to the set point of 350 - 500 °C and a small cylinder containing HCDZ in fluid communication with the ALD reactor were used to produce films on the wafers. The ALD reactor was purged with argon (Ar). Then ALD SiO₂ films were grown with HCDZ using following sequences: HCDZ dose, 3 sec / Ar Purge, 3 sec / oxidant containing gases, such as O₃ (ozone) / O₂ or H₂O, for 3 sec / Ar Purge, 3 sec. The foregoing sequence of steps were repeated until a silicon oxide film with a desired thickness is formed on the wafers. Next the films were tested for wet etch rate. The parameters for growing the films and the test results for the films are in Table 3 below.

**Table 3. Parameters and GPC and RI test results for Examples 16 to 28.**

| Example | Precursor | Oxidant | Set Temp (°C) | GPC (Å/cycle) | RI at 632.8nm |
|---|---|---|---|---|---|
| 16 | HCDZ | O₃/O₂ | 500 | 0.07 | 1.46 |
| 17 | HCDZ | O₃/O₂ | 550 | 0.07 | 1.46 |
| 18 | HCDZ | O₃/O₂ | 600 | 0.31 | 1.46 |
| 19 | HCDZ | O₃/O₂ | 625 | 0.24 | 1.46 |
| 20 | HCDZ | O₃/O₂ | 650 | 0.43 | 1.46 |
| 21 | HCDZ | O₃/O₂ | 675 | 0.58 | 1.46 |
| 22 | HCDZ | O₃/O₂ | 700 | 0.89 | 1.46 |
| 23 | HCDZ | O₃/O₂ | 750 | 1.19 | 1.46 |
| 24 | HCDZ | O₃/O₂ | 800 | 1.34 | 1.46 |
| 25 | HCDZ | H₂O | 550 | 0.03 | 1.46 |
| 26 | HCDZ | H₂O | 600 | 0.06 | 1.46 |
| 27 | HCDZ | H₂O | 650 | 0.23 | 1.46 |
| 28 | HCDZ | H₂O | 750 | 1.24 | 1.46 |

The below claims are incorporated by reference here, and the terms "claim" and "claims" are replaced by the term "aspect" or "aspects," respectively. Embodiments of the invention also include these resulting numbered aspects.

## Claims

1. A process of treating an initial surface of a substrate, the method comprising a first contacting step comprising contacting the initial surface of the substrate with a vapor of 1,1,3,3-tetrachlorodisilazane or 1,1,1,3,3,3-hexachlorodisilazane, using a first deposition method to give a treated surface on the substrate

2. A process for preparing a silicon-heteroatom compound, the method comprising a first contacting step comprising contacting the initial surface of the substrate with a vapor of 1,1,3,3-tetrachlorodisilazane or 1,1,1,3,3,3-hexachlorodisilazane using a first deposition method to give a treated surface on the substrate; and a second contacting step comprising contacting the initial surface or the treated surface of the substrate with a vapor or plasma of a precursor material containing nitrogen atom(s), oxygen atom(s), carbon atom(s), or a combination of any two or more atoms thereof using a second deposition method to give a product comprising a silicon-heteroatom compound formed with or on the initial or treated surface of the substrate.

3. The process of any one of claims 1 to 2 wherein the precursor material containing nitrogen atom(s) is molecular nitrogen, ammonia, hydrazine, an organohydrazine, hydrogen azide, a primary amine, or a secondary amine; the precursor material containing oxygen atom(s) is molecular oxygen, ozone, water, nitrous oxide, or hydrogen peroxide; and the precursor material containing carbon atom(s) is methane, ethane, propane, a butane, a chloromethylsilane, a permethylsilane having from 1 to 5 Si atoms, or a methylhydridosilane having 1 to 5 Si atoms.

4. The process of any one of claims 2 to 3 wherein the precursor material further contains silicon atom(s), hydrogen atom(s), chlorine atom(s), or a combination of any two or more atoms thereof.

5. The process of any one of claims 2 to 4 wherein the first contacting step is completed before the second contacting step is performed such that the second contacting step comprises contacting the treated surface of the substrate with the vapor or plasma of a precursor material; or the method comprises atomic layer deposition; or both.

6. The process of any one of claims 2 to 4 wherein the first and second contacting steps are performed simultaneously such that the second contacting step comprises contacting the initial surface of the substrate with the vapor or plasma of a precursor material; or the method comprises chemical vapor deposition; or both.

7. The process of any one of claims 2 to 6 wherein the silicon-heteroatom compound that is made is a silicon carbide, a silicon nitride, a silicon dioxide, a silicon oxynitride, a silicon carbonitride, a silicon oxycarbide, or a silicon oxycarbonitride; or wherein the silicon-heteroatom compound is made in the shape of a film on the initial surface of substrate; or both.

8. The process of any one of claims 2 to 7 further comprising a step of separating the silicon-heteroatom compound of the product from the substrate of the product so as to give the separated silicon-heteroatom compound as a free-standing bulk form.

9. The silicon-heteroatom compound made by the process of any one of claims 2 to 7.

10. A manufactured article comprising the product obtainable by the process of any one of claims 1 to 8 or the silicon-heteroatom compound of claim 9.
